# EUROPEAN PATENT SPECIFICATION

(11) **EP 4 644 921 B1**
(45) Date of publication and mention of the grant of the patent: **21.10.2026**
(21) Application number: 24895169.1
(22) Date of filing: 29.05.2024
(51) Int. Cl.: G01R 31/12, H01M 10/48, G01R 31/20

(54) **CONDUCTIVE-PARTICLE-COVERING DIELECTRIC WITHSTAND TESTING METHOD**
TESTVERFAHREN FÜR DIELEKTRISCHE BESTÄNDIGKEIT MIT ABDECKUNG LEITFÄHIGER PARTIKEL
PROCÉDÉ DE TEST DE TENSION DE TENUE D'ISOLATION REVÊTUE DE PARTICULES CONDUCTRICES

(30) Priority: 13.03.2024 CN 202410284665
(43) Date of publication of application: 05.11.2025
(73) Proprietor: Jiangsu Changhong Intelligent Equipment Co., Ltd., Yancheng, Jiangsu 224000 (CN)
(72) Inventor: QIU, Eileen, Yancheng, Jiangsu 224000 (CN); LIN, Jianhua, Yancheng, Jiangsu 224000 (CN); LIU, Li, Yancheng, Jiangsu 224000 (CN); YU, Guanhua, Yancheng, Jiangsu 224000 (CN)
(74) Representative: Bayramoglu et al.
(86) International application number: PCT/CN2024/095949
(87) International publication number: WO 2025/189566

(56) References cited:
- CN-A- 107 664 738
- CN-A- 110 873 625
- CN-U- 208 904 178
- CN-U- 220 305 438
- DE-A1- 102012 214 738
- DE-A1- 102012 214 738
- DE-A1- 102021 129 520
- DE-U1- 202022 106 801
- DE-U1- 202022 106 801
- KR-B1- 101 840 011

## Description

### TECHNICAL FIELD

The present disclosure relates to the technical field of cell production and testing, and in particular to a conductive-particle-covering dielectric withstand testing method.

### BACKGROUND TECHNOLOGY

A cell is an independent small battery. Many cells are connected in series and parallel to form a battery module. Regardless of cylindrical cells or prismatic cells, insulation is required between the cells as well as between the cell and the tray, and insulation performance of a cell casing must meet certain requirements. Otherwise, any leakage will result in thermal runaway of the cell to cause a safety accident. Hence, it is essential to test the insulation performance of the cell casing in production and assembly of the cell.

At present, there are two common insulation testing methods for a coating of the cell casing: point-sampling testing and conductive-rubber-covering testing. Point-sampling testing has the omission of not being tested on an unqualified point. Testing with conductive rubber as a conducting medium for covering the cell also has a problem, namely a problem of reliable attachment between the conductive rubber and the insulating coating. Due to repeated contact and collision between the cell and the conductive rubber, or an inherent quality problem of the conductive rubber, a void (a bubble or an air gap) is formed between the conducting medium and the insulating coating. Due to a high impedance of the void, an insulation flaw on the coating of the cell is concealed, resulting in the outflow of the cell with unqualified insulation. DE 10 2012 214738 A1 is known from the prior art and it discloses a method for testing the electrical insulation of the surface of electrical components, in particular for testing the insulation of hardcase battery cell housings, by means of a testing device. In this case, by means of at least one electrode arranged in the test device, which is suitably dimensioned and reversibly deformable, the entire insulated component surface or a region to be tested of the insulated component surface is electrically contacted in such a way for evaluating its insulation that also three-dimensional partial regions of the region to be tested are electrically contacted by means of the electrode independently of their shape and/or cracked partial regions of the region to be tested, and/or partial regions of the region to be tested, which have a mechanical sensitivity below a predetermined threshold value, are electrically contacted by means of the electrode without damage.

### CONTENT OF THE INVENTION

The present disclosure provides a conductive-particle-covering dielectric withstand testing method, to solve problems in the background.

To achieve the above objective, the present disclosure provides the following technical solutions: A conductive-particle-covering dielectric withstand testing method includes the following steps:
A: press-fitting an electrode-protecting cover plate to an electrode on an insulating layer of a cell to form a target cell;
B: moving the target cell to a metallic trough;
C: filling a conductive particle between the metallic trough and an insulating layer of the target cell;
D: connecting a ground terminal of a dielectric withstand tester to the target cell through a lead;
E: connecting a high-voltage terminal of the dielectric withstand tester to the metallic trough through a second lead; and
F: testing the target cell with the dielectric withstand tester.

Preferably, before the step A of press-fitting the electrode-protecting cover plate to the electrode on the insulating layer of the cell to form the target cell, an elastic adhesive tape is mounted under the electrode-protecting cover plate, and an electrode groove is formed in the elastic adhesive tape.

Preferably, the electrode-protecting cover plate is press-fitted, until the electrode is completely covered by the electrode groove.

Preferably, after the step B of moving the target cell to the metallic trough, the target cell and the metallic trough are adjusted to be concentric.

Preferably, the step C of filling the conductive particle between the metallic trough and the insulating layer of the target cell includes keeping the target cell stable in the metallic trough, and filling the conductive particle into the metallic trough from bottom to top.

Preferably, the conductive particle is filled into the metallic trough from bottom to top, until a height of the filled conductive particle is higher than a top end of the insulating layer of the cell.

Preferably, the conductive particle includes one or more kinds of a tin particle, a silver particle, a gold particle, a platinum particle, and a stainless steel grit particle.

Preferably, the conductive particle has a particle size of 0.1-1 mm.

Preferably, the step D of connecting the ground terminal of the dielectric withstand tester to the target cell through the lead includes piercing the electrode-protecting cover plate and the elastic adhesive tape sequentially with a probe connected to the lead, until a bottom end of the probe comes in contact with a top end of a positive electrode of the target cell.

Preferably, the step F of testing the target cell with the dielectric withstand tester includes recording measured data of the dielectric withstand tester, and comparing the measured data with theoretical reference data to determine whether the target cell is qualified.

The present disclosure has the following beneficial effects:
According to the solutions provided by the present disclosure:
Since the insulating coating of the target cell is fully covered by the conductive particles, a void (a bubble or an air gap) is not formed between the conducting medium and the insulating coating, and an insulation flaw on the coating of the cell is not concealed for a high impedance of the void, thereby preventing outflow of a product with unqualified insulation.

### DESCRIPTION OF THE DRAWINGS

FIG. 1 is a flowchart of a process according to the present disclosure; and
FIG. 2 is a sectional view of a metallic trough according to the present disclosure.

In the figures: 1: cell, 2: electrode-protecting cover plate, 3: target cell, 4: metallic trough, 5: dielectric withstand tester, and 6: ground terminal.

### SPECIFIC IMPLEMENTATIONS

The preferred embodiments of the present disclosure are described below with reference to the accompanying drawings. It should be understood that the preferred embodiments described herein are only used to illustrate the present disclosure, rather than to limit the present disclosure.

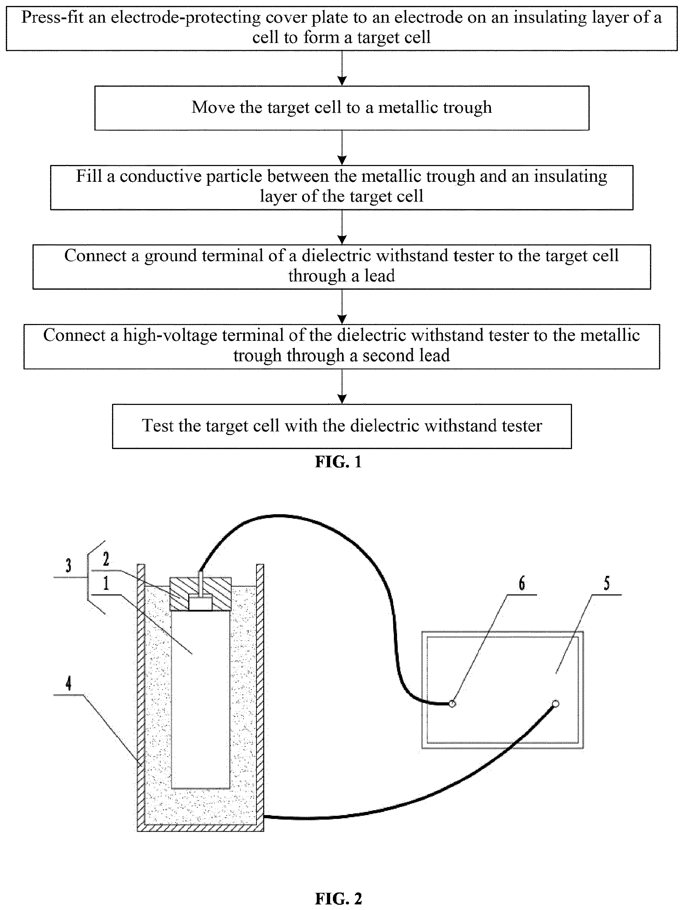

**Embodiment: Referring to** **FIG. 1 and FIG. 2****,** a conductive-particle-covering dielectric withstand testing method includes the following steps;
A: Electrode-protecting cover plate 2 is press-fitted to an electrode on an insulating layer of cell 1 to form target cell 3.
B: The target cell 3 is moved to metallic trough 4.
C: A conductive particle is filled between the metallic trough 4 and an insulating layer of the target cell 3.
D: Ground terminal 6 of dielectric withstand tester 5 is connected to the target cell 3 through a lead.
E: A high-voltage terminal of the dielectric withstand tester 5 is connected to the metallic trough 4 through a second lead.
F: The target cell 3 is tested with the dielectric withstand tester 5.

The above solution has the following principle and beneficial effect:
The electrode-protecting cover plate 2 is press-fitted to the electrode on the insulating layer of the cell 1 to form the target cell 3. The target cell 3 is put into the metallic trough 4. The conductive particle is filled between the metallic trough 4 and the insulating layer of the target cell 3. After the conductive particle is filled, the ground terminal 6 of the dielectric withstand tester 5 is connected to the target cell 3 with the lead. The high-voltage terminal of the dielectric withstand tester 5 is connected to the metallic trough 4 with the second lead. The model of the dielectric withstand tester 5 is TOS9300. The dielectric withstand tester 5 is started to power on the target cell 3 and the metallic trough 4, thereby testing insulation performance of an insulating coating of the cell. Since the insulating coating of the target cell 3 is fully covered by the conductive particles, a void (a bubble or an air gap) is not formed between the conducting medium and the insulating coating, and an insulation flaw on the coating of the cell is not concealed for a high impedance of the void, thereby preventing outflow of a product with unqualified insulation.

Before the step A in which the electrode-protecting cover plate 2 is press-fitted to the electrode on the insulating layer of cell 1 to form target cell 3, an elastic adhesive tape is mounted under the electrode-protecting cover plate 2, and an electrode groove is formed in the elastic adhesive tape.

The above solution has the following principle and beneficial effect:
With the elastic adhesive tape under the electrode-protecting cover plate 2, a breakdown of the electrode-protecting cover plate 2 in a dielectric withstand test on the target cell 3, or a short circuit between electrodes for a highly conductive substance on the electrode-protecting cover plate 2 to cause scrapping of the target cell 3, can be prevented.

The electrode-protecting cover plate 2 is press-fitted, until the electrode is completely covered by the electrode groove.

The above solution has the following principle and beneficial effect:
A circular groove is formed in the elastic adhesive tape under the electrode-protecting cover plate 2. The circular groove can further enhance an insulating effect between the electrodes. Meanwhile, by covering the electrode through the circular groove, the electrode-protecting cover plate 2 and the target cell 3 can be press-fitted better. Since the electrode is covered by the circular groove after press-fitted, the electrode-protecting cover plate 2 can be firmly mounted on a top end of the target cell 3. When the target cell 3 is to be moved or the target cell 3 is impacted by an external force, the electrode-protecting cover plate 2 is not separated from the target cell 3. After the electrode-protecting cover plate 2 is press-fitted completely relative to the target cell 3, the elastic adhesive tape under the electrode-protecting cover plate 2 can further seal the top end of the target cell 3 well, preventing the conductive particles from entering an electrode plane in the test. In view of inherent conductivity of the conductive particles, the electrode-protecting cover plate 2 provided with the elastic adhesive tape can prevent the conductive particles from entering the electrode plane of the cell to cause a short circuit of the cell.

After the step B in which the target cell 3 is moved to metallic trough 4, the target cell 3 and the metallic trough 4 are adjusted to be concentric.

The above solution has the following principle and beneficial effect:
After the target cell 3 and the metallic trough 4 are adjusted to be concentric, the conductive particle is filled. Since the target cell 3 and the metallic trough 4 are concentric, each sidewall of the target cell 3 keeps a same distance with an inner wall of the metallic trough 4. This ensures a uniform thickness for the filled conductive particles in a horizontal direction, and further ensures a uniform resistance between the target cell 3 and the metallic trough 4, preventing a voltage difference on the insulating coating at the sidewall of the target cell 3 when the target cell 3 is tested, preventing omission of testing on an insulation flaw due to a small voltage on a part of the insulating coating, and further improving reliability of the method in the test.

In the step C: A conductive particle is filled between the metallic trough 4 and an insulating layer of the target cell 3, the target cell 3 is kept stable in the metallic trough 4, and the conductive particle is filled into the metallic trough 4 from bottom to top.

The above solution has the following principle and beneficial effect:
When the conductive particle is added to the metallic trough 4, the target cell 3 is kept stable in the metallic trough 4. This ensures that the target cell 3 is concentric with the metallic trough 4 all the time, ensures a uniform thickness for the conductive particles between the target cell 3 and the metallic trough 4, and further ensures that a voltage applied to the insulating coating at the sidewall of the target cell 3 is the same, preventing omission of testing caused by a voltage difference or a breakdown of the insulating coating due to the voltage difference.

The conductive particle is filled into the metallic trough 4 from bottom to top, until a height of the filled conductive particle is higher than a top end of the insulating layer of the cell 1.

The above solution has the following principle and beneficial effect:
When a height of the filled conductive particle is higher than the top end of the insulating layer of the cell 1, the conductive particle is not filled. This ensures that the to-be-tested insulating coating of the target cell 3 can be completely covered by the conductive particles, preventing omission of testing after the dielectric withstand tester 5 is powered on.

The conductive particle includes one or more kinds of a tin particle, a silver particle, a gold particle, a platinum particle, and a stainless steel grit particle.

The above solution has the following principle and beneficial effect:
In production of the cell, a large number of tin, silver, gold and platinum materials are used. Some materials are remained in the form of wear debris as residual particles in the machining process. The residual particles may be classified, or collected intensively as conductive particles, saving the invested cost in the production and reducing environmental pollution. The conductive particle may also be made of stainless steel grit. The stainless steel grit has a low cost and a long service life. When the conductive particle includes one of the tin, the silver, the gold, the platinum and the stainless steel grit according to an actual condition, not only is the difficulty in recycling classification reduced, but also the cost in the test can be controlled effectively, and the conductive particle can be applied to the actual testing process conveniently and quickly.

The conductive particle has a particle size of 0.1-1 mm.

The above solution has the following principle and beneficial effect:
The particle size of the conductive particle is 0.1-1 mm. Through repeated dielectric withstand tests, when the particle size of the conductive particle is 0.1-1 mm, the conductive particle is not scattered in movement of the target cell 3 for the excessively small particle size of the conductive particle, and the omission of testing on the insulating layer for the overlarge gap between the conductive particles caused by the excessively large particle size of the conductive particle is prevented.

Since the conductive material is made of a solid material with the particle size of 0.1-1 mm, after the target cell 3 is tested, the qualified target cell 3 is taken out and cleaned simply for packaging. This improves the testing efficiency, and reduces the product cleaning difficulty.

Through long-term production practices, since the conductive particle has the particle size of 0.1-1 mm, and the conductive material is made of the tin, silver, gold and platinum material, the insulating coating of the target cell 3 is not worn when put into the conductive particles or taken out from the conductive particles, improving an intact rate of the target cell 3.

In the step D: Ground terminal 6 of dielectric withstand tester 5 is connected to the target cell 3 through a lead, the electrode-protecting cover plate 2 and the elastic adhesive tape are sequentially pierced with a probe connected to the lead, until a bottom end of the probe comes in contact with a top end of a positive electrode of the target cell 3.

The above solution has the following principle and beneficial effect:
The electrode-protecting cover plate 2 and the elastic adhesive tape are sequentially pierced with the probe connected to the lead. The bottom end of the probe comes in contact with the top end of the positive electrode of the target cell 3. After the electrode-protecting cover plate 2 and the elastic adhesive tape are pierced by the probe, since the probe suffers a force of friction from the elastic adhesive tape and the electrode-protecting cover plate 2, the probe can be stably placed on the electrode-protecting cover plate 2. Meanwhile, since the probe comes in contact with the positive electrode, while the probe is stable, the probe can keep desirable contact with the positive electrode. This ensures that when the dielectric withstand tester 5 is powered on, the voltage applied to the insulating coating of the target cell 3 is stable.

In the step F: The target cell 3 is tested with the dielectric withstand tester 5, measured data of the dielectric withstand tester 5 is recorded, and the measured data is compared with theoretical reference data to determine whether the target cell 3 is qualified.

The above solution has the following principle and beneficial effect:
Before the dielectric withstand test is carried out, the theoretical reference data of the target cell 3 is obtained through an experiment or theoretical calculation. When the target cell 3 is tested with the dielectric withstand tester 5, the measured data of the dielectric withstand tester 5 is recorded, and the measured data is compared with the theoretical reference data to determine whether the insulating coating of the target cell 3 has an insulation flaw. This improves the testing efficiency.

The invention is defined by the appended claims.

## Claims

1. A conductive-particle-covering dielectric withstand testing method, **characterized by** comprising the following steps:
A: press-fitting an electrode-protecting cover plate (2) to an electrode on an insulating layer of a cell (1) to form a target cell (3);
B: moving the target cell (3) to a metallic trough (4);
C: filling a conductive particle between the metallic trough (4) and the insulating layer of the target cell (3);
D: connecting a ground terminal (6) of a dielectric withstand tester (5) to the target cell (3) through a lead;
E: connecting a high-voltage terminal of the dielectric withstand tester (5) to the metallic trough (4) through a second lead; and
F: testing the target cell (3) with the dielectric withstand tester (5).

2. The conductive-particle-covering dielectric withstand testing method according to claim 1, **characterized in that** before the step A of press-fitting the electrode-protecting cover plate (2) to the electrode on the insulating layer of the cell (1) to form the target cell (3), an elastic adhesive tape is mounted under the electrode-protecting cover plate (2), and an electrode groove is formed in the elastic adhesive tape.

3. The conductive-particle-covering dielectric withstand testing method according to claim 2, **characterized in that** the electrode-protecting cover plate (2) is press-fitted, until the electrode is completely covered by the electrode groove.

4. The conductive-particle-covering dielectric withstand testing method according to claim 1, **characterized in that** after the step B of moving the target cell (3) to the metallic trough (4), the target cell (3) and the metallic trough (4) are adjusted to be concentric.

5. The conductive-particle-covering dielectric withstand testing method according to claim 1, **characterized in that** the step C of filling the conductive particle between the metallic trough (4) and the insulating layer of the target cell (3) comprises keeping the target cell (3) stable in the metallic trough (4), and filling the conductive particle into the metallic trough (4) from bottom to top.

6. The conductive-particle-covering dielectric withstand testing method according to claim 5, **characterized in that** the conductive particle is filled into the metallic trough (4) from bottom to top, until a height of the filled conductive particle is higher than a top end of the insulating layer of the cell (1).

7. The conductive-particle-covering dielectric withstand testing method according to claim 6, **characterized in that** the conductive particle comprises one or more kinds of a tin particle, a silver particle, a gold particle, a platinum particle, and a stainless steel grit particle.

8. The conductive-particle-covering dielectric withstand testing method according to claim 7, **characterized in that** the conductive particle has a particle size of 0.1-1 mm.

9. The conductive-particle-covering dielectric withstand testing method according to claim 1, **characterized in that** the step D of connecting the ground terminal (6) of the dielectric withstand tester (5) to the target cell (3) through the lead comprises piercing the electrode-protecting cover plate (2) and the elastic adhesive tape sequentially with a probe connected to the lead, until a bottom end of the probe comes in contact with a top end of a positive electrode of the target cell (3).

10. The conductive-particle-covering dielectric withstand testing method according to claim 1, **characterized in that** the step F of testing the target cell (3) with the dielectric withstand tester (5) comprises recording measured data of the dielectric withstand tester (5), and comparing the measured data with theoretical reference data to determine whether the target cell (3) is qualified.

## Patentansprüche

1. Spannungsfestigkeitsprüfverfahren für eine Abdeckung mittels leitfähigem Partikel, **dadurch gekennzeichnet, dass** es die folgenden Schritte umfasst:
A: Aufpressen einer Elektrodenschutzabdeckplatte (2) auf eine Elektrode auf einer isolierenden Schicht einer Zelle (1), um eine Zielzelle (3) zu bilden;
B: Bewegen der Zielzelle (3) in eine Metallwanne (4);
C: Füllen eines leitfähigen Partikels zwischen die Metallwanne (4) und die isolierende Schicht der Zielzelle (3);
D: Verbinden einer Erdungsklemme (6) einer Spannungsfestigkeitsprüfeinrichtung (5) mit der Zielzelle (3) über eine Leitung;
E: Verbinden einer Hochspannungsklemme der Spannungsfestigkeitsprüfeinrichtung (5) mit der Metallwanne (4) über eine zweite Leitung; und
F: Prüfen der Zielzelle (3) mit der Spannungsfestigkeitsprüfeinrichtung (5).

2. Spannungsfestigkeitsprüfverfahren für eine Abdeckung mittels leitfähigem Partikel nach Anspruch 1, **dadurch gekennzeichnet, dass** vor dem Schritt A des Aufpressens der Elektrodenschutzabdeckplatte (2) auf die Elektrode auf der isolierenden Schicht der Zelle (1), um eine Zielzelle (3) zu bilden, ein elastisches Klebeband unter der Elektrodenschutzabdeckplatte (2) angebracht wird und eine Elektrodennut in dem elastischen Klebeband gebildet wird.

3. Spannungsfestigkeitsprüfverfahren für eine Abdeckung mittels leitfähigem Partikel nach Anspruch 2, **dadurch gekennzeichnet, dass** die Elektrodenschutzabdeckplatte (2) so lange aufgepresst wird, bis die Elektrode vollständig mit der Elektrodennut bedeckt ist.

4. Spannungsfestigkeitsprüfverfahren für eine Abdeckung mittels leitfähigem Partikel nach Anspruch 1, **dadurch gekennzeichnet, dass** nach dem Schritt B des Bewegens der Zielzelle (3) in die Metallwanne (4) die Zielzelle (3) und die Metallwanne (4) konzentrisch zueinander ausgerichtet werden.

5. Spannungsfestigkeitsprüfverfahren für eine Abdeckung mittels leitfähigem Partikel nach Anspruch 1, **dadurch gekennzeichnet, dass** der Schritt C des Füllens des leitfähigen Partikels zwischen die Metallwanne (4) und die isolierende Schicht der Zielzelle (3) stabiles Halten der Zielzelle (3) in der Metallwanne (4) und Füllen des leitfähigen Partikels in die Metallwanne (4) von unten nach oben umfasst.

6. Spannungsfestigkeitsprüfverfahren für eine Abdeckung mittels leitfähigem Partikel nach Anspruch 5, **dadurch gekennzeichnet, dass** der leitfähige Partikel von unten nach oben in die Metallwanne (4) gefüllt wird, bis eine Höhe des eingefüllten leitfähigen Partikels höher als ein oberes Ende der isolierenden Schicht der Zelle (1) ist.

7. Spannungsfestigkeitsprüfverfahren für eine Abdeckung mittels leitfähigem Partikel nach Anspruch 6,
**dadurch gekennzeichnet, dass** das leitfähige Partikel eine oder mehrere Arten von einem Zinnpartikel, einem Silberpartikel, einem Goldpartikel, einem Platinpartikel und einem Stahlsandpartikel umfasst.

8. Spannungsfestigkeitsprüfverfahren für eine Abdeckung mittels leitfähigem Partikel nach Anspruch 7, **dadurch gekennzeichnet, dass** das leitfähige Partikel eine Partikelgröße von 0,1 bis 1 mm aufweist.

9. Spannungsfestigkeitsprüfverfahren für eine Abdeckung mittels leitfähigem Partikel nach Anspruch 1, **dadurch gekennzeichnet, dass** der Schritt D des Verbindens der Erdungsklemme (6) der Spannungsfestigkeitsprüfeinrichtung (5) mit der Zielzelle (3) über die Leitung aufeinanderfolgendes Durchstechen der Elektrodenschutzabdeckplatte (2) und des elastischen Klebebands mit einer Sonde, die mit der Leitung verbunden ist, umfasst, bis ein unteres Ende der Sonde mit einem oberen Ende einer positiven Elektrode der Zielzelle (3) in Kontakt gelangt.

10. Spannungsfestigkeitsprüfverfahren für eine Abdeckung mittels leitfähigem Partikel nach Anspruch 1, **dadurch gekennzeichnet, dass** der Schritt F des Prüfens der Zielzelle (3) mit der Spannungsfestigkeitsprüfeinrichtung (5) Aufzeichnen von Messdaten der Spannungsfestigkeitsprüfeinrichtung (5) und Vergleichen der Messdaten mit theoretischen Referenzdaten umfasst, um zu bestimmen, ob die Zielzelle (3) geeignet ist.

## Revendications

1. Procédé de test de résistance diélectrique recouvrant des particules conductrices, **caractérisé par** les étapes suivantes :
A : ajustement par pression d'une plaque de couverture de protection d'électrode (2) sur une électrode sur une couche isolante d'une cellule (1) pour former une cellule cible (3) ;
B : déplacer la cellule cible (3) vers une goulotte métallique (4) ;
C : remplir une particule conductrice entre la goulotte métallique (4) et la couche isolante de la cellule cible (3) ;
D : raccorder une borne de masse (6) d'un testeur de résistance diélectrique (5) à la cellule cible (3) via un câble ;
E : raccorder une borne haute tension du testeur de résistance diélectrique (5) à la goulotte métallique (4) via un deuxième câble ; et
F : tester la cellule cible (3) avec le testeur de résistance diélectrique (5).

2. Procédé de test de résistance diélectrique recouvrant des particules conductrices selon la revendication 1, **caractérisé en ce que**, avant l'étape A d'ajustement par pression de la plaque de couverture de protection de l'électrode (2) à l'électrode de la couche isolante de la cellule (1) pour former la cellule cible (3), un ruban adhésif élastique est monté sous la plaque de couverture de protection de l'électrode (2), et une rainure d'électrode est formée dans le ruban adhésif élastique.

3. Procédé de test de résistance diélectrique recouvrant des particules conductrices selon la revendication 2, **caractérisé en ce que** la plaque de couverture de protection de l'électrode (2) est ajustée par pression, jusqu'à ce que l'électrode soit entièrement recouverte par la rainure de l'électrode.

4. Procédé de test de résistance diélectrique recouvrant des particules conductrices selon la revendication 1, **caractérisé en ce qu'**après l'étape B de déplacement de la cellule cible (3) vers la goulotte métallique (4), la cellule cible (3) et la goulotte métallique (4) sont ajustées pour être concentriques.

5. Procédé de test de résistance diélectrique recouvrant des particules conductrices selon la revendication 1, **caractérisé en ce que** l'étape C de remplissage de la particule conductrice entre la goulotte métallique (4) et la couche isolante de la cellule cible (3) consiste à maintenir la cellule cible stable (3) dans la goulotte métallique (4), et à remplir la particule conductrice dans la goulotte métallique (4) de bas en haut.

6. Procédé de test de résistance diélectrique recouvrant des particules conductrices selon la revendication 5, **caractérisé en ce que** la particule conductrice est remplie dans la goulotte métallique (4) de bas en haut, jusqu'à ce qu'une hauteur de la particule conductrice remplie soit supérieure à l'extrémité supérieure de la couche isolante de la cellule (1).

7. Procédé de test de résistance diélectrique recouvrant des particules conductrices selon la revendication 6, **caractérisé en ce que** la particule conductrice comprend un ou plusieurs types de particules d'étain, d'argent, d'or, de platine et de grains d'acier inoxydable.

8. Procédé de test de résistance diélectrique recouvrant des particules conductrices selon la revendication 7, **caractérisé en ce que** la particule conductrice a une taille de particule de 0,1 à 1 mm.

9. Procédé de test de résistance diélectrique recouvrant des particules conductrices selon la revendication 1, **caractérisé en ce que** l'étape D de raccordement de la borne de masse (6) du testeur de résistance diélectrique (5) à la cellule cible (3) via le câble consiste à percer séquentiellement la plaque de couverture de protection d'électrode (2) et le ruban adhésif élastique avec une sonde reliée au câble, jusqu'à ce qu'une extrémité inférieure de la sonde entre en contact avec l'extrémité supérieure d'une électrode positive de la cellule cible (3).

10. Procédé de test de résistance diélectrique recouvrant des particules conductrices selon la revendication 1, **caractérisé en ce que** l'étape F du test de la cellule cible (3) avec le testeur de résistance diélectrique (5) consiste à enregistrer les données mesurées du testeur de résistance diélectrique (5), et à comparer les données mesurées avec des données de référence théoriques afin de déterminer si la cellule cible (3) est qualifiée.
